# EUROPEAN PATENT APPLICATION

(11) **EP 4 726 721 A1**
(43) Date of publication of application: **15.04.2026**
(21) Application number: 25206300.3
(22) Date of filing: 02.10.2025
(51) Int. Cl.: G11C 7/10, G06F 13/16, H04L 25/49

(54) **MEMORY CONTROLLER WITH OVERSAMPLING MEMORY I/O**

(30) Priority: 02.10.2024 US 202463702607 P; 02.10.2024 US 202463702615 P; 23.09.2025 US 202519337063
(71) Applicant: MEDIATEK INC., Hsinchu City 30078 (TW)
(72) Inventor: KUMAR, Arvind, San Jose, California (US); KUMASHIKAR, Mahesh K., San Jose, California, (US); NALAMALPU, Ankireddy, San Jose, California (US)
(74) Representative: Haseltine Lake Kempner LLP

(57) **Abstract**

**A memory** controller in an integrated circuit system includes a receiver circuit that performs oversampling in time and voltage. The receiver circuit receives a data signal modulated with pulse amplitude modulation (PAM) having N signal levels from a memory module over a data lane, N > 2. The receiver circuit generates K samples by sampling the data signal at a sequence of time points in a unit time interval. The receiver circuit uses R voltage comparator blocks to generate R signal level estimates from the same sample out of the K samples. The voltage comparator blocks compare the same sample against (N-1) voltage thresholds with different offsets configured for different voltage comparator blocks. The receiver circuit identifies one of the N signal levels to which the data signal is mapped based on all signal level estimates generated from the K samples, and outputs a symbol corresponding to the identified signal level.

## Description

### TECHNICAL FIELD

Embodiments of the invention relate to memory controllers and memory I/O techniques in an integrated circuit system.

### BACKGROUND OF THE INVENTION

Modem memory controllers support high efficiency and low latency data transfer between a processor and a memory device. A memory controller translates and coordinates high-level memory access requests from a processor into low-level electrical signals that read from or write to the memory. Based on the memory access requests, the memory controller determines which row and column in a memory cell array to access.

A memory controller also schedules memory I/O commands from a processor, such as read, write, activate (row access), precharge (row close), and refresh to the memory based on timing rules. Additionally, the memory controller performs timing management and read/write data buffering to manage differences in data rates or timing between the processor and the memory.

Modern high-speed memory I/O requires memory controllers to handle a large amount of data transfer at high frequencies. The high data rates can cause signal integrity issues. Noise, distortion, crosstalk, and intersymbol interference become significant problems that can corrupt data. A robust transceiver is needed to maintain the signal integrity. The designs of memory controllers continue evolving to support faster, larger, and more power-efficient computing. The demands on memory controllers with respect to timing, power, and reliability continue to grow. Therefore, there is a need for further improvement of memory controller technologies.

### SUMMARY OF THE INVENTION

In one embodiment, a method is performed by a receiver circuit in a memory controller in an integrated circuit system. The method comprises receiving a data signal modulated with pulse amplitude modulation (PAM) having N signal levels from a memory module over a data lane, N being an integer greater than 2. The method further comprises generating K samples by sampling the data signal at a sequence of time points in a unit time interval, K being an in-phase oversampling factor; and generating R signal level estimates from a same one of the K samples by R voltage comparator blocks. The R voltage comparator blocks compare the same sample against (N-1) voltage thresholds with different offsets configured for different voltage comparator blocks, and R is a quadrature-phase oversampling factor. The method further comprises identifying one of the N signal levels to which the data signal is mapped based on all signal level estimates generated from the K samples; and outputting a symbol corresponding to the identified signal level.

In another embodiment, a memory controller in an integrated circuit system includes a transmitter module to send outgoing data to a memory module and a receiver module including a plurality of receiver circuits to receive incoming data. The incoming data is modulated with PAM having N signal levels from the memory module over multiple data lanes, N being an integer greater than 2. Each receiver circuit includes K samplers that sample a data signal received on a data lane at a sequence of time points in a unit time interval to generate K sample, and K signal level detectors to receive the K samples, respectively, K being an in-phase oversampling factor. Each signal level detector includes R voltage comparator blocks and R is a quadrature-phase oversampling factor. The R voltage comparator blocks are operative to compare a same one of the K samples against (N-1) voltage thresholds with different offsets configured for different voltage comparator blocks to thereby generate R signal level estimates. Each receiver circuit further includes a decision circuit. The decision circuit identifies one of the N signal levels to which the data signal is mapped based on all signal level estimates generated from the K samples, and outputs a symbol corresponding to the identified signal level.

Other aspects and features will become apparent to those ordinarily skilled in the art upon review of the following description of specific embodiments in conjunction with the accompanying figures.

### BRIEF DESCRIPTION OF DRAWINGS

The present invention is illustrated by way of example, and not by way of limitation, in the figures of the accompanying drawings in which like references indicate similar elements. It should be noted that different references to "an" or "one" embodiment in this disclosure are not necessarily to the same embodiment, and such references mean at least one. Further, when a particular feature, structure, or characteristic is described in connection with an embodiment, it is submitted that it is within the knowledge of one skilled in the art to effect such feature, structure, or characteristic in connection with other embodiments whether or not explicitly described.
FIG. 1 is a block diagram illustrating an integrated circuit system in which embodiments of the invention may operate.
FIG. 2 is a block diagram illustrating an Rx module in a memory controller according to one embodiment.
FIG. 3 is a block diagram illustrating an Rx circuit per data lane according to one embodiment.
FIG. 4 is a block diagram illustrating a signal level detector according to one embodiment.
FIG. 5A is a block diagram illustrating a signal quality monitor operative to monitor the quality of received signals according to one embodiment.
FIG. 5B is a block diagram illustrating a control circuit operative to control the amount of oversampling according to one embodiment.
FIG. 6 is a flow diagram illustrating a method performed by a memory controller according to one embodiment.
FIG. 7A, FIG. 7B, FIG. 7C, and FIG. 7D illustrate a memory controller connecting to different types of memory modules according to some embodiments.

### DETAILED DESCRIPTION OF THE INVENTION

In the following description, numerous specific details are set forth. However, it is understood that embodiments of the invention may be practiced without these specific details. In other instances, well-known circuits, structures, and techniques have not been shown in detail in order not to obscure the understanding of this description. It will be appreciated, however, by one skilled in the art, that the invention may be practiced without such specific details. Those of ordinary skill in the art, with the included descriptions, will be able to implement appropriate functionality without undue experimentation.

This disclosure describes receiver circuits in a memory controller that can oversample received signals from a memory module in both time and voltage domains. In one embodiment, the memory controller communicates with the memory module using pulse amplitude modulation (PAM) with more than two signal levels. The order of PAM refers to the number of distinct signal levels that represent the symbols transmitted with PAM. For example, "PAM-N" means that N signal levels are used to represent the symbols transmitted with PAM. A higher-order PAM means a larger N value. Using a higher-order PAM means transmitting more bits per symbol, which increases throughput without needing to increase the symbol rate. For the same bit rate, a higher-order PAM allows for a slower symbol rate, which reduces intersymbol interferences and crosstalks.

However, there are tradeoffs in raising the order of the PAM. As the number of signal levels increases, the amplitude difference between each level decreases, leading to a smaller eye opening. The signal-to-noise ratio (SNR) requirement rises significantly with higher-order PAM due to the reduced eye opening. To improve the SNR of a high-order PAM signal received by a memory controller, the receiver circuits in the memory controller oversample the received signal. The oversampling may be performed in time to protect against voltage noise. Additionally or alternatively, the oversampling may be performed at multiple voltage levels to protect against timing noise. The oversampling in time is referred to as "in-phase" or "I-phase" oversampling, and the oversampling in voltage is referred to as "quadrature-phase" or "Q-phase" oversampling. In the following description, specific orders of PAM are mentioned, e.g., PAM-4, PAM-8, PAM-16, etc. It is understood that the disclosed memory controller is not limited to the specific PAM mentioned herein.

In one embodiment, the receiver circuit in the memory controller may turn on and off the I-phase or the Q-phase sampling depending on the runtime channel conditions. The receiver circuit may be a matched receiver or an unmatched receiver.

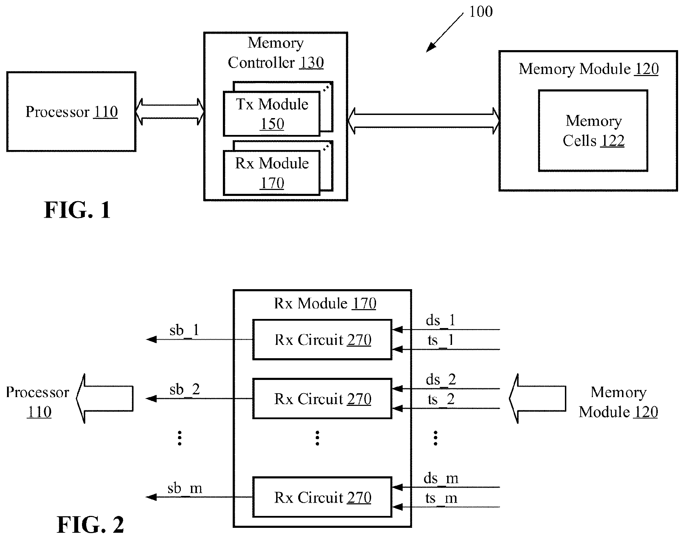

FIG. 1 is a block diagram illustrating an integrated circuit system 100 ("system 100") in which embodiments of the invention may operate. The system 100 includes a processor 110 coupled to a memory controller 130. The memory controller 130 reads from and writes to a memory module 120 when directed by the processor 110. The memory module 120 includes arrays of memory cells 122 for data storage. In one embodiment, the memory controller 130 may be co-located with the processor 110 on one chip, and the memory module 120 may be located outside of the chip. In another embodiment, the memory controller 130, the processor 110, and the memory module 120 may all co-located on the same chip.

Although one processor 110 is shown in FIG. 1, it is understood that the system 100 may include multiple processors and each processor may include one or more processing cores or computation units. Non-limiting examples of the processor 110 include, a central processing unit (CPU), a graphics processing unit (GPU), a digital signal processor (DSP), a neural processing unit (NPU), and any processing units that uses a memory controller to access the memory module 120.

The memory controller 130 includes one or more transmitter (Tx) modules 150 and one or more receiver (Rx) modules 170, among other components. The Tx module 150 and the Rx module 170 communicate with the memory module 120 to write to and read from, respectively, the memory cells 122 of the memory module 120.

FIG. 2 is a block diagram illustrating further details of the Rx module 170 according to one embodiment. The Rx module 170 includes multiple Rx circuits 270, and each Rx circuit 270 receives a data signal (*ds*) on a corresponding data lane. In one embodiment, the memory module 120 may transmit a timing signal (*ts*) to accompany the data signal for timing reference. In an alternative embodiment, the memory controller 130 may use its internal clock signal as the timing reference. In an embodiment where there are *m* data lanes between the memory controller 130 and the memory module 120, the Rx module 170 includes *m* Rx circuits 270 to receive and process the *m* data signals from the memory module 120. Each Rx circuit 270 detects the signal level of the data signal in each unit time interval based on the corresponding timing signal. The detected signal level is mapped to a bit group representing a symbol (*sb*) and sent to the processor 110. In one embodiment, the detected signal level may be mapped to Grey-coded bit groups. For PAM-4, there are 4 signal levels and each symbol contains 2 bits; for PAM-8, there are 8 signal levels and each symbol contains 3 bits; for PAM-16, there are 16 signal levels and each symbol contains 4 bits, and so on.

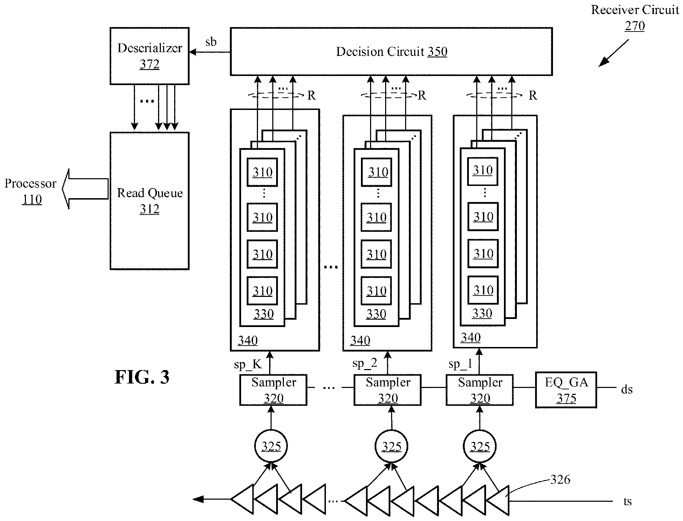

FIG. 3 is a block diagram illustrating one of the Rx circuits 270 according to one embodiment. The Rx circuit 270 includes, among other circuit components, an equalizer and gain amplifier circuit ("EQ_GA 375") to compensate for signal loss and distortion on the Rx path. An example of the EQ_GA 375 may include a VGA (voltage gain amplifier) and a CTLE (continuous-time linear equalizer). The placement of the EQ_GA 375 in FIG. 3 is illustrative and non-limiting. In one embodiment, the Rx circuit 270 receives both data signals (*ds*) and timing signals (*ts*) from the memory module 120. In an embodiment where the memory module 120 is a double data rate (DDR) or DDR-based memory module, an example of the data signal and the timing signal may be DQ and DQS, respectively.

In one embodiment, the Rx circuit 270 includes a sequence of samplers 320, each of which samples the received data signal at a sequence of time points within a unit time interval of time. The time points may be evenly spaced in time. Alternatively, the spacing between any two adjacent time points may be programmable. As a non-limiting example, the timing signal lane may include a delay chain of delay taps 326. Each sampler 320 receives timing input from a corresponding interpolator 325. The interpolator 325 performs a weighted interpolation of the timing signals at different delays to generate a timing signal with a fine-grain delay that aligns with the data sampling time of the corresponding sampler 320. The weights used by each interpolator 320 for timing signal interpolation are programmable. By programming the weights, the spacing between any two adjacent time points of data sampling can be programmed.

The outputs of the samplers 320 are a sequence of samples sp_1, sp_2, ..., sp_K, where K is the number of the samplers 320 in the sequence. Thus, the I-phase oversampling is achieved by the samplers 320 oversampling the data signal by a factor of K.

In one embodiment, each sample is sent to a signal level detector 340, which includes R voltage comparator blocks 330. Each voltage comparator block 330 includes (N-1) comparators 310 to compare the voltage level of the sample with (N-1) voltage thresholds, where N is the order of the PAM and is greater than 2. The output of each voltage comparator block 330 is a signal level estimate corresponding to a bit group (i.e., a symbol) of log₂(N) bits.

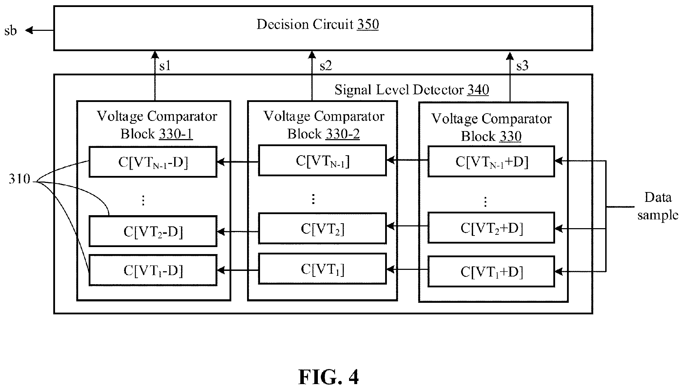

Each voltage comparator block 330 produces one signal level estimate. Different voltage comparator blocks 330 uses different voltage thresholds for their respective comparators 310. The Q-phase oversampling is achieved by the signal level detector 340 oversampling a data sample by a factor of R. More details about the Q-phase oversampling will be provided with reference to FIG. 4.

As there are K signal level detectors 340 and each signal level detector 340 produces R signal level estimates, the total number of signal level estimates is (R x K) for the data signal on a data lane in a unit of time interval. A decision circuit 350 in the receiver circuit 270 identifies a signal level based on the (R x K) signal level estimates and maps the identified signal level to a symbol (i.e., a bit group). A deserializer 372 converts the incoming high-speed serial data stream of bit groups into parallel data for downstream circuit components to perform further processing. The processed data may be stored in a read queue 312 before being forwarded to the processor 110 (FIG. 1).

For example, the identified signal level may be the signal level estimate that has the most votes, i.e., the most repeated signal level estimate out of the total (R x K) signal level estimates. As another example, the identified signal level may be the signal level estimate that is equal to or the closest to the average or weighted average of the total (R x K) signal level estimates. A weighted average may be used by the decision circuit 330 to emphasize some signal level estimates over the others. In some embodiments, the decision circuit 350 may assign a weight to each of the R x K signal level estimates. For example, the signal level estimate generated from one of the K samplers 320 or by one of the R voltage comparator blocks 330 may be assigned a higher weight than one or more other signal level estimates in the same unit time interval.

FIG. 4 is a block diagram illustrating one of the signal level detectors 340 according to one embodiment. Referring also to FIG. 3, each sampler 320 outputs a data sample to a corresponding signal level detector 340. Each signal level detector 340 includes R voltage comparator blocks 330. For simplicity of illustration, R = 3 is shown in this example and the three voltage comparator blocks are labeled 330-1, 330-2, and 330-3 (collectively referred to as voltage comparator blocks 330). It is understood that R can be any positive integer. Each voltage comparator block 330 includes (N-1) comparators 310 to compare a data sample with (N-1) voltage thresholds, respectively, where N is the order of the PAM used for memory I/O and is greater than 2. In the example of PAM-4, the voltage level (v) of the data sample is compared with 3 voltage thresholds (e.g., VT1, VT2, and VT3) that define the 4 signal levels of PAM-4 (e.g., v < VT1, VT1 < v < VT2, VT2 < v < VT3, and v > VT3). With the I-phase oversampling and/or the Q-phase oversampling, a high-order PAM such as PAM-8 or PAM-16 may be used. The voltage level of the data sample is compared with 7 voltage thresholds and 15 voltage thresholds in the case of PAM-8 and PAM-16, respectively.

The Q-phase oversampling is achieved by the R voltage comparator blocks 330. Each voltage comparator block 330 includes (N-1) comparators 310. In FIG. 4, each comparator 310 is denoted as C[VTᵢ + offset], where VT represents the voltage threshold, i is an index from 1 to (N-1), and offset can be a positive number, a negative number, or zero. The comparators 310 in the same voltage comparator block 330 are configured with the same offset. Different voltage comparator blocks 330 are configured with different offsets. In one embodiment, the offsets of the voltage comparator blocks 330 in the same signal level detector 340 may be evenly spaced. For example, the voltage comparator block 330-1 has an offset -D, the voltage comparator block 330-2 has zero offset, and the voltage comparator block 330-3 has an offset D. In some embodiments, the offset of each voltage comparator block 330 may be individually programmable.

As a result, the data sample goes through R x (N-1) comparisons and R signal level estimates are produced. The decision circuit 350 collects R signal level estimates for each of the K samples in each unit time interval and determines a symbol output.

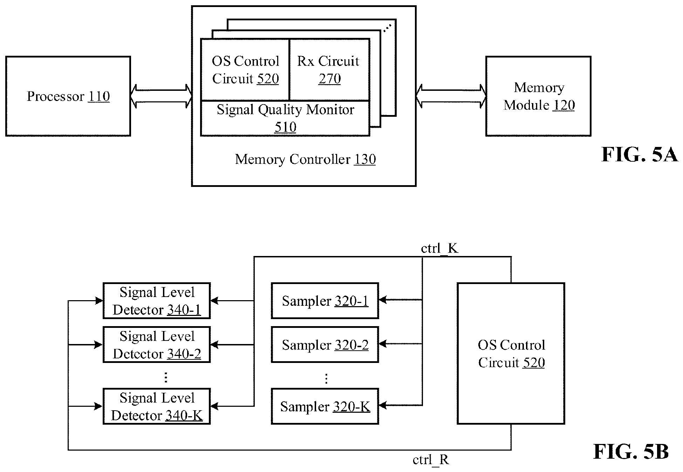

FIG. 5A is a block diagram illustrating a signal quality monitor 510 operative to monitor the quality of received signals according to one embodiment. In this embodiment, the memory controller 130 includes a signal quality monitor 510 for each data lane to monitor the received signal quality (e.g., the noise level or the SNR), which may include both the data signal quality and the timing signal quality. Based on the received signal quality, an oversampling (OS) control circuit 520 in the memory controller 130 may dynamically adjust the amount of I-phase and Q-phase oversampling in the Rx circuit 270 for each data lane. Referring also to FIG. 3, when the noise of the data signal is below a threshold, the OS control circuit 520 may deactivate one or more samplers 320 (as well as the corresponding signal level detectors 340) and/or one or more voltage comparator blocks 330 to decrease the amount of oversampling. The signal level detector 340 that receives data samples from a given sampler 320 is the "corresponding signal level detector 340" to the given sampler 320. For a data path that is substantially noise-free, the OS control circuit 520 may activate only one sampler 320, one signal level detector 340, and one voltage comparator block 330 in the one signal level detector 340. When the noise level is above a threshold, the OS control circuit 520 may activate additional samplers 320 and/or voltage comparator blocks 330 to increase the amount of oversampling. In one embodiment, each of the samplers 320 and the signal level detectors 340 is power-gated. Activating and deactivating a sampler 320 and the corresponding signal level detectors 340 means turning on and off, respectively, the power to the sampler 320 and the signal level detectors 340.

FIG. 5B is a block diagram illustrating the OS control circuit 520 operative to control the amount of oversampling according to one embodiment. The OS control circuit 520 can selectively activate and deactivate one or more of the samplers 320 and the corresponding signal level detectors 340. For example, the samplers 320-1, 320-2, ..., 320-K (collectively referred to the samplers 320) correspond to the signal level detectors 340-1, 340-2, ..., 340-K (collectively referred to the signal level detectors 340), respectively. The OS control circuit 520 may adjust the I-phase oversampling factor K and/or the Q-phase oversampling factor R based on the received signal quality. In some embodiments, the oversampling factors K and R may be reduced when there is a need to reduce power consumption.

In one embodiment, the OS control circuit 520 generates a control signal etrl_K to each of the samplers 320 and the signal level detectors 340 to control the I-phase oversampling factor K. When the voltage noise increases, the OS control circuit 520 may activate more of the K samplers 320 and the corresponding signal level detectors 340. When the voltage noise decreases, the OS control circuit 520 may deactivate some of the samplers 320 and the corresponding signal level detectors 340. In a low-noise or noise-free scenario, all but one sampler 320 (and the corresponding signal level detector 340) may be deactivated; that is, the I-phase oversampling may be deactivated.

In one embodiment, the OS control circuit 520 generates a control signal ctrl_R to each of the signal level detectors 340 to control the Q-phase oversampling factor R. When the timing noise increases, the OS control circuit 520 may activate more of the R voltage comparator blocks 330 in each signal level detector 340. When the timing noise decreases, the OS control circuit 520 may deactivate one or more of the voltage comparator blocks 330 in each signal level detector 340. In a low-noise or noise-free scenario, all but one voltage comparator block 330 in each signal level detector 340 may be deactivated; that is, the Q-phase oversampling may be deactivated. In one embodiment, each of the voltage comparator blocks 330 is power-gated. Activating and deactivating a voltage comparator block 330 means turning on and off, respectively, the power to the voltage comparator block 330. In one embodiment, the decision circuit 350 may adjust the weighting, if any is used, of the signal level estimates based on the received signal quality.

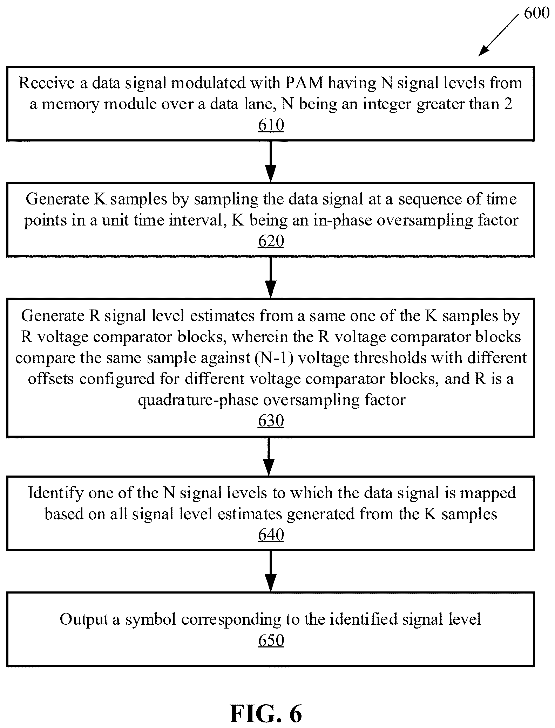

FIG. 6 is a flow diagram illustrating a method 600 performed by a receiver circuit in a memory controller in an integrated circuit system according to one embodiment. An example of the receiver circuit may be the receiver circuit 270 (FIG. 3). The method 600 starts at step 610 when the receiver circuit receives a data signal from a memory module in the integrated circuit system over a data lane, where the data signal is modulated with PAM having N signal levels and N is an integer greater than 2. The receiver circuit at step 620 generates K samples by sampling the data signal at a sequence of time points in a unit time interval, where K is an in-phase oversampling factor. The receiver circuit at step 630 uses R voltage comparator blocks to generate R signal level estimates from the same one of the K samples. The R voltage comparator blocks compare the same sample against (N-1) voltage thresholds with different offsets configured for different voltage comparator blocks, where R is a quadrature-phase oversampling factor. The receiver circuit at step 640 identifies one of the N signal levels to which the data signal is mapped based on all voltage level estimates generated from the K samples, and at step 650 outputs a symbol corresponding to the identified signal level.

Step 630 is performed for each of the K samples. In one embodiment, the receiver circuit generates K sets of R signal level estimates from the K samples and produces a total of (K x R) signal level estimates in the unit time interval. In one embodiment, the identified signal level is the one signal level that is the most repeated among the all signal level estimates. In another embodiment, a decision circuit in the memory controller calculates an average of all signal level estimates, and identifies the one signal level that is equal to or the closest to the average among all of the signal level estimates. In yet another embodiment, the signal level estimates may be weighted. The decision circuit assigns a weight to each signal level estimate, calculates a weighted average of all of the signal level estimates, and identifies the one signal level that is equal to or the closest to the weighted average among all of the signal level estimates.

In one embodiment, the offsets and spacing of the time points may be programmable. In one embodiment, when the receiver circuit receives an indication of signal quality of the received signals, the receiver circuit is to activate or deactivate one or more of samplers that sample the K samples to increase or decrease the in-phase oversampling factor K based on the signal quality. In one embodiment, the signal quality may be indicated by a voltage noise level in the data signal. In one embodiment, when the receiver circuit receives an indication of signal quality of the received signals, the receiver circuit is to activate or deactivate one or more of the R voltage comparator blocks to increase or decrease the quadrature oversampling factor R based on the signal quality. In one embodiment, the signal quality may be indicated by a timing noise level in a timing signal accompanying the data signal. In one embodiment, the data signal is modulated with PAM-8. In another embodiment, the data signal is modulated with PAM-16.

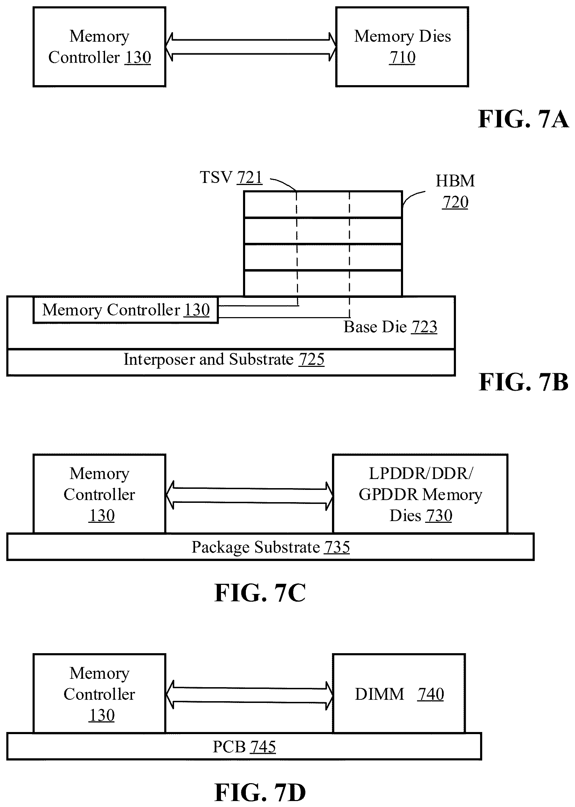

FIG. 7A-FIG. 7D illustrate the memory controller 130 connecting to different types of memory modules according to some embodiments. FIG. 7A shows that the memory controller 130 is connected to one or more memory dies 710. The memory dies 710 can be fabricated by any known fabrication technologies and can communicate with the memory controller 130 according to any known memory I/O protocols. For example, the memory dies 710 may be a dynamic random access memory (DRAM), synchronous DRAM (SDRAM), ferroelectric RAM (FeRAM), phase-change memory (PCM), etc. In FIG. 7B, the memory controller 130 communicates with a high bandwidth memory (HBM) module 720 that includes memory dies arranged in a vertical stack and accessible via TSVs 721. The memory controller 130 and the HBM modules 720 may be co-located on a base die 723, which is on top an interposer and substrate 725. It is noted that stacked memory technologies are not limited to the HBM module 720. The aforementioned memory controller 130 can operate with memory stacks formed by other memory technologies, such as low-power double data rate (LPDDR) memory stacks. In one embodiment, LPDDR memory dies may be wire-bonded into a vertical stack, with the bottom LPDDR die wire-bonded to a package substrate. Alternatively, the LPDDR memory stack may be encapsulated in a package. FIG. 7C shows the memory controller 130 in communication with DDR-based memory dies 730 such as DDR4, DDR5, DDR6, LPDDR, graphics DDR (GDDR) memory dies. The memory controller 130 and the DDR-based memory dies 730 may be co-located on the same package substrate 735. Alternatively, the DDR-based memory dies 730 may be in a separate package from the memory controller 130. FIG. 7D shows the memory controller 130 in communication with a DIMM 740 containing multiple memory dies. The memory controller 130 and the DIMM 740 may be co-located on the same printed circuit board (PCB) 745. The memory controller 130 in FIG. 7A-FIG. 7D performs the aforementioned oversampling operations. More specifically, the memory controller 130 in FIG. 7A-FIG. 7D performs the method 600 (FIG. 6).

The operations of the flow diagram of FIG. 6 have been described with reference to the exemplary embodiments of FIG. 1-4, 5A, 5B, and 7. However, it should be understood that the operations of the flow diagram of FIG. 6 can be performed by embodiments of the invention other than the embodiments of FIG. 1-4, 5A, 5B, and 7, and these embodiments can perform operations different than those discussed with reference to the flow diagram. While the flow diagram of FIG. 6 shows a particular order of operations performed by certain embodiments of the invention, it should be understood that such order is exemplary (e.g., alternative embodiments may perform the operations in a different order, combine certain operations, overlap certain operations, etc.).

Various functional components or blocks have been described herein. As will be appreciated by persons skilled in the art, the functional blocks will preferably be implemented through circuits (either dedicated circuits or general-purpose circuits, which operate under the control of one or more processors and coded instructions), which will typically comprise transistors that are configured in such a way as to control the operation of the circuitry in accordance with the functions and operations described herein.

While the invention has been described in terms of several embodiments, those skilled in the art will recognize that the invention is not limited to the embodiments described, and can be practiced with modification and alteration within the spirit and scope of the appended claims. The description is thus to be regarded as illustrative instead of limiting.

Various embodiments are set out in the following numbered clauses:
Clause 1. A method of a receiver circuit in a memory controller in an integrated circuit system, comprising: receiving a data signal modulated with pulse amplitude modulation (PAM) having N signal levels from a memory module in the integrated circuit system over a data lane, N being an integer greater than 2; generating K samples by sampling the data signal at a sequence of time points in a unit time interval, K being an in-phase oversampling factor; generating R signal level estimates from a same one of the K samples by R voltage comparator blocks, wherein the R voltage comparator blocks compare the same sample against (N-1) voltage thresholds with different offsets configured for different voltage comparator blocks, and R is a quadrature-phase oversampling factor; identifying one of the N signal levels to which the data signal is mapped based on all signal level estimates generated from the K samples; and outputting a symbol corresponding to the identified signal level.
Clause 2. The method of clause 1, wherein generating the R signal level estimates further comprises: generating K sets of R signal level estimates from the K samples; and producing a total of (K x R) signal level estimates in the unit time interval.
Clause 3. The method of clause 1, wherein identifying one of the N signal levels further comprises: identifying the one signal level that is the most repeated among the all signal level estimates.
Clause 4. The method of clause 1, wherein identifying one of the N signal levels further comprises: calculating an average of the all signal level estimates; and identifying the one signal level that is equal to or the closest to the average among the all signal level estimates.
Clause 5. The method of clause 1, wherein identifying one of the N signal levels further comprises: assigning a weight to each of the all signal level estimates; calculating a weighted average of the all signal level estimates; and identifying the one signal level that is equal to or the closest to the weighted average among the all signal level estimates.
Clause 6. The method of clause 1, wherein the offsets and spacing of the time points are programmable.
Clause 7. The method of clause 1, further comprising: receiving an indication of signal quality of received signals; and activating or deactivating one or more of samplers that sample the K samples to increase or decrease the in-phase oversampling factor K based on the signal quality.
Clause 8. The method of clause 1, further comprising: receiving an indication of signal quality of received signals; and activating or deactivating one or more of the R voltage comparator blocks to increase or decrease the quadrature oversampling factor R based on the signal quality.
Clause 9. The method of clause 1, wherein the data signal is modulated with PAM-8.
Clause 10. The method of clause 1, wherein the data signal is modulated with PAM-16.
Clause 11. A memory controller in an integrated circuit system, comprising: a transmitter module to send outgoing data to a memory module in the integrated circuit system; and a receiver module including a plurality of receiver circuits to receive incoming data modulated with pulse amplitude modulation (PAM) having N signal levels from the memory module over a plurality of data lanes, N being an integer greater than 2, each receiver circuit including: a plurality of (K) samplers that sample a data signal received on a data lane at a sequence of time points in a unit time interval to generate K samples, K being an in-phase oversampling factor; a plurality of (K) signal level detectors to receive the K samples, respectively, wherein each signal level detector includes a plurality of (R) voltage comparator blocks and R is a quadrature-phase oversampling factor, and wherein the R voltage comparator blocks are operative to compare a same one of the K samples against (N-1) voltage thresholds with different offsets configured for different voltage comparator blocks to thereby generate R signal level estimates; and a decision circuit that identifies one of the N signal levels to which the data signal is mapped based on all signal level estimates generated from the K samples, and outputs a symbol corresponding to the identified signal level.
Clause 12. The memory controller of clause 11, wherein the K signal level detectors are further operative to: generate K sets of R signal level estimates from the K samples; and produce a total of (K x R) signal level estimates in the unit time interval.
Clause 13. The memory controller of clause 11, wherein the decision circuit is further operative to: identify the one signal level that is the most repeated among the all signal level estimates.
Clause 14. The memory controller of clause 11, wherein the decision circuit is further operative to: calculate an average of the all signal level estimates; and identify the one signal level that is equal to or the closest to the average among the all signal level estimates.
Clause 15. The memory controller of clause 11, wherein the decision circuit is further operative to: assign a weight to each of the all signal level estimates; calculate a weighted average of the all signal level estimates; and identify the one signal level that is equal to or the closest to the weighted average among the all signal level estimates.
Clause 16. The memory controller of clause 11, wherein the offsets and spacing of the time points are programmable.
Clause 17. The memory controller of clause 11, further comprising: a signal quality detector to detect signal quality of received signals; and an oversampling control circuit to activate or deactivate one or more of the K samplers to increase or decrease the in-phase oversampling factor K based on the signal quality.
Clause 18. The memory controller of clause 17, wherein the signal quality is indicated by a voltage noise level in the data signal.
Clause 19. The memory controller of clause 11, further comprising: a signal quality detector to detect signal quality of received signals; and an oversampling control circuit to activate or deactivate one or more of the R voltage comparator blocks in each signal level detector to increase or decrease the quadrature oversampling factor R based on the signal quality.
Clause 20. The memory controller of clause 19, wherein the signal quality is indicated by a timing noise level in a timing signal accompanying the data signal.

## Claims

1. A method of a receiver circuit in a memory controller (130) in an integrated circuit system (100), comprising:
receiving (610) a data signal modulated with pulse amplitude modulation, PAM, having N signal levels from a memory module (120) in the integrated circuit system (100) over a data lane, N being an integer greater than 2;
generating (620) K samples by sampling the data signal at a sequence of time points in a unit time interval, K being an in-phase oversampling factor;
generating (630) R signal level estimates from a same one of the K samples by R voltage comparator blocks (330), wherein the R voltage comparator blocks (330) compare the same sample against (N-1) voltage thresholds with different offsets configured for different voltage comparator blocks (330), and R is a quadrature-phase oversampling factor;
identifying (640) one of the N signal levels to which the data signal is mapped based on all signal level estimates generated from the K samples; and
outputting (650) a symbol corresponding to the identified signal level.

2. The method of claim 1, wherein generating the R signal level estimates further comprises:
generating K sets of R signal level estimates from the K samples; and
producing a total of (K x R) signal level estimates in the unit time interval.

3. The method of claim 1, wherein identifying one of the N signal levels further comprises:
identifying the one signal level that is the most repeated among the all signal level estimates.

4. The method of claim 1, wherein identifying one of the N signal levels further comprises:
calculating an average of the all signal level estimates; and
identifying the one signal level that is equal to or the closest to the average among the all signal level estimates.

5. The method of claim 1, wherein identifying one of the N signal levels further comprises:
assigning a weight to each of the all signal level estimates;
calculating a weighted average of the all signal level estimates; and
identifying the one signal level that is equal to or the closest to the weighted average among the all signal level estimates.

6. The method of any one of claims 1 to 5, further comprising:
receiving an indication of signal quality of received signals; and
activating or deactivating one or more of samplers (320) that sample the K samples to increase or decrease the in-phase oversampling factor K based on the signal quality.

7. The method of any one of claims 1 to 5, further comprising:
receiving an indication of signal quality of received signals; and
activating or deactivating one or more of the R voltage comparator blocks (330) to increase or decrease the quadrature oversampling factor R based on the signal quality.

8. A memory controller (130) in an integrated circuit system (100), comprising:
a transmitter module to send outgoing data to a memory module (120) in the integrated circuit system (100); and
a receiver module including a plurality of receiver circuits to receive incoming data modulated with pulse amplitude modulation, PAM, having N signal levels from the memory module (120) over a plurality of data lanes, N being an integer greater than 2, each receiver circuit including:
a plurality of (K) samplers (320) that sample a data signal received on a data lane at a sequence of time points in a unit time interval to generate K samples, K being an in-phase oversampling factor;
a plurality of (K) signal level detectors (340) to receive the K samples, respectively, wherein each signal level detector (340) includes a plurality of (R) voltage comparator blocks (330)and R is a quadrature-phase oversampling factor, and wherein the R voltage comparator blocks (330) are operative to compare a same one of the K samples against (N-1) voltage thresholds with different offsets configured for different voltage comparator blocks (330) to thereby generate R signal level estimates; and
a decision circuit (350) that identifies one of the N signal levels to which the data signal is mapped based on all signal level estimates generated from the K samples, and outputs a symbol corresponding to the identified signal level.

9. The memory controller (130) of claim 8, wherein the K signal level detectors (340) are further operative to:
generate K sets of R signal level estimates from the K samples; and
produce a total of (K x R) signal level estimates in the unit time interval.

10. The memory controller (130) of claim 8 or 9, wherein the decision circuit (350) is further operative to:
identify the one signal level that is the most repeated among the all signal level estimates.

11. The memory controller (130) of claim 8, wherein the decision circuit (350) is further operative to:
calculate an average of the all signal level estimates; and
identify the one signal level that is equal to or the closest to the average among the all signal level estimates.

12. The memory controller of claim 8, wherein the decision circuit (350) is further operative to:
assign a weight to each of the all signal level estimates;
calculate a weighted average of the all signal level estimates; and
identify the one signal level that is equal to or the closest to the weighted average among the all signal level estimates.

13. The memory controller (130) of claim 8, further comprising:
a signal quality detector to detect signal quality of received signals; and
an oversampling control circuit (520) to activate or deactivate one or more of the K samplers (320) to increase or decrease the in-phase oversampling factor K based on the signal quality.

14. The memory controller (130) of claim 8, further comprising:
a signal quality detector to detect signal quality of received signals; and
an oversampling control circuit (520) to activate or deactivate one or more of the R voltage comparator blocks (330) in each signal level detector (340) to increase or decrease the quadrature oversampling factor R based on the signal quality.

15. The memory controller (130) of claim 14, wherein the signal quality is indicated by a timing noise level in a timing signal accompanying the data signal.
